# EUROPÄISCHE PATENTANMELDUNG

(11) **EP 4 576 944 A1**
(43) Veröffentlichungstag der Anmeldung: **25.06.2025**
(21) Anmeldenummer: 23219214.6
(22) Anmeldetag: 21.12.2023
(51) Int. Cl.: H05G 1/26, H05G 1/54, H05G 1/46, G01R 19/165

(54) **MESSSYSTEM FÜR EINEN BIPOLAREN HOCHSPANNUNGSGENERATOR**

(71) Anmelder: Siemens Healthineers AG, 91301 Forchheim (DE)
(72) Erfinder: Sturm, Leander, 95490 Mistelgau (DE)
(74) Vertreter: Siemens Healthineers Patent Attorneys

(57) **Zusammenfassung**

Die Erfindung betrifft ein Messsystem (10) für einen bipolaren Hochspannungsgenerator (20), aufweisend
- einen ersten Messkanal (11) zum Erfassen des negativen Röhrenstroms (N_IT) und der negativen Röhrenspannung (N_UT),
- einen zweiten Messkanal (12) zum Erfassen des positiven Röhrenstroms (P_IT) und der positiven Röhrenspannung (P_UT),
- eine Schnittstelle (13) zwischen dem ersten Messkanal (11) und dem zweiten Messkanal (12), wobei die Schnittstelle (13) zum Übertragen mittels des ersten Messkanals (11) erfasster erster Messwerte des negativen Röhrenstroms (N_IT) und der negativen Röhrenspannung (N_UT) und/oder mittels des zweiten Messkanals (12) erfasster zweiter Messwerte des positiven Röhrenstroms (P_IT) und der positiven Röhrenspannung (P_UT) ausgebildet ist,
- eine Steuerlogik (14) zum Empfangen der ersten Messwerte sowie der zweiten Messwerte,
- wobei die Steuerlogik (14) zum Vergleichen der empfangenen Messwerte mit mindestens einem Grenzwert ausgebildet ist,
- wobei die Steuerlogik (14) zum Ausgeben eines Steuersignals in Abhängigkeit einer beim Vergleichen der empfangenen Messwerte erfolgenden Grenzwertverletzung ausgebildet ist.

## Beschreibung

Die Erfindung betrifft ein Messsystem für einen bipolaren Hochspannungsgenerator, den bipolaren Hochspannungsgenerator, einen Röntgenstrahler, ein Verfahren zum Ausgeben eines Steuersignals mittels eines Messsystems und ein zugehöriges Computerprogrammprodukt.

Hochspannungsgeneratoren erzeugen typischerweise Hochspannungen zum Betreiben von herkömmlichen Röntgenstrahlern. In Röntgenstrahlern werden mittels der Hochspannung Elektronen von einer Kathode in Richtung einer Anode beschleunigt, um bei einer Wechselwirkung der beschleunigten Elektronen auf der Anode Röntgenstrahlung generieren zu können.

Röntgenstrahler können insbesondere dahingehend unterschieden werden, ob eine der beiden Elektroden, Anode oder Kathode, auf Massepotential liegt. In diesem Fall ist der Röntgenstrahler ein unipolarer Röntgenstrahler.

Wenn an beiden Elektroden, der Anode und der Kathode, Hochspannung mit gegensätzlichen Vorzeichen anliegt, ist der Röntgenstrahler ein bipolarer Röntgenstrahler. Ein solcher bipolarer Röntgenstrahler erfordert insbesondere einen bipolaren Hochspannungsgenerator, welcher dazu eingerichtet ist, einen negativen Röhrenstrom, eine negative Röhrenspannung, einen positiven Röhrenstrom und eine positive Röhrenspannung zu erzeugen sowie paarweise an einem negativen Hochspannungsausgang und an einem positiven Hochspannungsausgang bereitzustellen.

Aufgrund der verwendeten Hochspannungen sind Hochspannungsgeneratoren und/oder Röntgenstrahler, insbesondere als medizinische elektrische Geräte, regelmäßig gemäß regulatorischen Vorgaben, insbesondere IEC- und/oder DIN-Normen, auszulegen. Beispielsweise sieht IEC 60601-1 Klausel 4.7 grundsätzlich eine Erstfehlersicherheit für medizinische elektrische Geräte vor. Demnach darf von einem medizinischen elektrischen Gerät im Fall eines ersten Fehlers kein Risiko entstehen. Bei der vorliegenden Geräteklasse der Hochspannungsgeneratoren und/oder der Röntgenstrahler ist insbesondere für diesen Zweck eine Überwachung von Röhrenspannung und Röhrenstrom sinnvoll.

Dem Erfinder ist ein einkanaliger Ansatz zur erstfehlersicheren Erfassung von Röhrenspannung und Röhrenstrom als Stand der Technik bekannt. Dabei werden Röhrenspannung und Röhrenstrom typischerweise analog aufbereitet und mittels eines Analog-Digital-Wandlers in einer Steuerlogik digitalisiert, bevor die digitalisierten Messwerte bei einem Sollwertvergleich für den einen Kanal bewertet werden.

Ein solches einkanaliges Messsystem erfordert typischerweise zusätzliche Maßnahmen, um die vorgeschriebene Erstfehlersicherheit gewährleisten zu können. Insbesondere kann ein Selbsttest der Messstrecken mittels Fehlerinjektion, eine Überwachung der funktionsrelevanten Versorgungsspannungen, eine Überwachung der Bauteiltemperatur von relevanten Komponenten und/oder ein externer Watchdog-Baustein zur Überwachung des Microcontrollers als Teil des einkanaliges Messsystems implementiert sein.

Der Erfindung liegt die Aufgabe zu Grunde, ein Messsystem für einen bipolaren Hochspannungsgenerator, einen bipolaren Hochspannungsgenerator, einen Röntgenstrahler, ein Verfahren zum Ausgeben eines Steuersignals mittels eines Messsystems und ein zugehöriges Computerprogrammprodukt mit einer geringeren Komplexität anzugeben.

Die Aufgabe wird durch die Merkmale der unabhängigen Ansprüche gelöst. Vorteilhafte Ausgestaltungen sind in den Unteransprüchen beschrieben.

Unabhängig vom grammatikalischen Geschlecht eines bestimmten Begriffes sind Personen mit männlicher, weiblicher oder anderer Geschlechteridentität mit umfasst.

Das erfindungsgemäße Messsystem für einen bipolaren Hochspannungsgenerator, wobei der bipolare Hochspannungsgenerator zur Erzeugung eines negativen Röhrenstroms, einer negativen Röhrenspannung, eines positiven Röhrenstroms und einer positiven Röhrenspannung ausgebildet ist, weist
- einen ersten Messkanal zum Erfassen des negativen Röhrenstroms und der negativen Röhrenspannung,
- einen zweiten Messkanal zum Erfassen des positiven Röhrenstroms und der positiven Röhrenspannung auf,
   gekennzeichnet durch
- eine Schnittstelle zwischen dem ersten Messkanal und dem zweiten Messkanal, wobei die Schnittstelle zum Übertragen mittels des ersten Messkanals erfasster erster Messwerte des negativen Röhrenstroms und der negativen Röhrenspannung und/oder mittels des zweiten Messkanals erfasster zweiter Messwerte des positiven Röhrenstroms und der positiven Röhrenspannung ausgebildet ist,
- eine Steuerlogik zum Empfangen der ersten Messwerte sowie der zweiten Messwerte,
- wobei die Steuerlogik zum Vergleichen der empfangenen Messwerte mit mindestens einem Grenzwert ausgebildet ist,
- wobei die Steuerlogik zum Ausgeben eines Steuersignals in Abhängigkeit einer beim Vergleichen der empfangenen Messwerte erfolgenden Grenzwertverletzung ausgebildet ist.

Das erfindungsgemäße Verfahren zum Ausgeben eines Steuersignals mittels des erfindungsgemäßen Messsystems umfasst die Schritte:
- Erfassen eines negativen Röhrenstroms und einer negativen Röhrenspannung mittels eines ersten Messkanals des Messsystems,
- Erfassen eines positiven Röhrenstroms und einer positiven Röhrenspannung mittels eines zweiten Messkanals des Messsystems,
- Übertragen mittels des ersten Messkanals erfasster erster Messwerte des negativen Röhrenstroms und der negativen Röhrenspannung und/oder mittels des zweiten Messkanals erfasster zweiter Messwerte des positiven Röhrenstroms und der positiven Röhrenspannung mittels einer Schnittstelle des Messsystems,
- Empfangen der ersten Messwerte sowie der zweiten Messwerte mittels einer Steuerlogik des Messsystems,
- Vergleichen der empfangenen Messwerte mit mindestens einem Grenzwert mittels der Steuerlogik,
- Ausgeben eines Steuersignals in Abhängigkeit einer beim Vergleichen der empfangenen Messwerte erfolgten Grenzwertverletzung mittels der Steuerlogik.

Ein Vorteil der Erfindung ist, dass insbesondere die im Stand der Technik nötigen zusätzlichen Maßnahmen zumindest teilweise und je nach Ausführungsform der vorliegenden Erfindung gänzlich entfallen können. Dadurch ist die Komplexität des Messsystems und/oder des Erfassens des Röhrenstroms und/oder der Röhrenspannung verringert.

Insbesondere ist keine typischerweise aufwändige Selbsttestschaltung und/oder kein eigenständiger Watchdog-Baustein nötig. Alternativ oder zusätzlich entfällt eine Versorgungsspannungsüberwachung.

Ein weiterer Vorteil der Erfindung betrifft, dass im Vergleich zum Stand der Technik die Fehlererkennung erweitert ist. Insbesondere kann ein Ursprung des Fehlers lokalisiert und/oder bestimmten Komponenten des Hochspannungsgenerators zugeordnet werden. Beispielsweise kann ein Fehler in einem Hochspannungsteiler mittels der Röhrenspannung und/oder in einem Messwiderstand mittels des Röhrenstroms erkannt werden.

Insgesamt kommt mit der geringeren Komplexität eine höhere Robustheit des Messsystems und/oder beim Erfassen des Röhrenstroms und/oder der Röhrenspannung einher. Insbesondere kann das Messsystem kostengünstiger sein aufgrund der geringeren Komplexität.

Das Messsystem ist für einen bipolaren Hochspannungsgenerator eingerichtet. Grundsätzlich ist das erfindungsgemäße Messsystem zusätzlich für einen unipolaren Hochspannungsgenerator anwendbar. In letzterem Fall ist der unipolare Hochspannungsgenerator insbesondere mit einer redundanten Röhrenstrom- und Röhrenspannungserfassung ausgestattet, wobei der erste Messkanal und der zweite Messkanal dieselben Messgrößen erfassen. Alternativ ist es denkbar, dass der Röhrenstrom und die Röhrenspannung mittels eines einzigen Messkanals erfasst und dann in zwei Messkanälen ausgewertet werden.

Der erfindungsgemäße bipolare Hochspannungsgenerator ist zur Erzeugung eines negativen Röhrenstroms, einer negativen Röhrenspannung, eines positiven Röhrenstroms und einer positiven Röhrenspannung ausgebildet und weist auf
- ein erfindungsgemäßes Messsystem,
- einen negativen Hochspannungsausgang, an welchem der negative Röhrenstrom und die negative Röhrenspannung bereitstellbar sind,
- einen positiven Hochspannungsausgang, an welchem der positive Röhrenstrom und die positive Röhrenspannung bereitstellbar sind,
- wobei der erste Messkanal mit dem negativen Hochspannungsausgang für das Erfassen des negativen Röhrenstroms und der negativen Röhrenspannung verschaltet ist,
- wobei der zweite Messkanal mit dem positiven Hochspannungsausgang für das Erfassen des positiven Röhrenstroms und der positiven Röhrenspannung verschaltet ist.

Der bipolare Hochspannungsgenerator kann insbesondere Hochspannungen zwischen 20 und 150 kV erzeugen. Die negative Röhrenspannung beträgt beispielsweise -75 kV und die positive Röhrenspannung beträgt beispielsweise +75 kV. Die negative Röhrenspannung und die positive Röhrenspannung sind insbesondere Gleichspannungen.

Der bipolare Hochspannungsgenerator kann eine Hochspannungseinheit für das Erzeugen von Röhrenströmen und/oder Röhrenspannungen umfassen. Die Hochspannungseinheit kann für die Erzeugung der negativen Röhrenspannung eine erste sekundärseitige Transformatorwicklung mit nachgeschaltetem Gleichrichter und für die Erzeugung der positiven Röhrenspannung eine zweite sekundärseitige Transformatorwicklung mit nachgeschaltetem Gleichrichter umfassen. Ein Ausgang des Gleichrichters für die negative Röhrenspannung bildet typischerweise den negativen Hochspannungsausgang. Ein Ausgang des Gleichrichters für die positive Röhrenspannung bildet typischerweise den positiven Hochspannungsausgang.

Eine erste primärseitige Transformatorwicklung und/oder eine zweite primärseitige Transformatorwicklung der Hochspannungseinheit wird insbesondere von einem Wechselrichter gespeist. Das Wechselrichtersignal zur Regelung des Wechselrichters kann beispielsweise von der Steuerlogik erzeugt und/oder ausgegeben werden.

Das Bereitstellen des positiven Röhrenstroms und des negativen Röhrenstroms an den Hochspannungsausgängen umfasst insbesondere, dass ein Röhrenstrom bei der positiven Röhrenspannung vom positiven Hochspannungsausgang ausgehen und im Wesentlichen dieser Röhrenstrom bei der negativen Röhrenspannung beim negativen Hochspannungsausgang eingehen kann. Der positive Röhrenstrom und der negative Röhrenstrom fließen insbesondere im selben Stromkreis über den Röntgenstrahler als Last und weisen in Bezug auf den Hochspannungsgenerator eine verschiedene Polarität auf. Idealerweise betrachtet entspricht insbesondere der negative Röhrenstrom dem positiven Röhrenstrom und/oder die negative Röhrenspannung der positiven Röhrenspannung.

Der Begriff Hochspannungsausgang ist insbesondere gleichbedeutend mit dem Begriff Hochspannungskontakt. Die Hochspannungsausgänge des bipolaren Hochspannungsgenerators können insbesondere als Hochspannungsbuchsen oder Hochspannungsanschlüsse ausgebildet sein.

Der erfindungsgemäße Röntgenstrahler weist auf
- den erfindungsgemäßen bipolaren Hochspannungsgenerator,
- ein evakuiertes Gehäuse,
- eine Kathode und
- eine Anode,
- wobei die Kathode und die Anode innerhalb des evakuierten Gehäuses angeordnet sind,
- wobei die Anode mit dem positiven Hochspannungsausgang verschaltet ist und
- wobei die Kathode mit dem negativen Hochspannungsausgang verschaltet ist.

Der Röntgenstrahler weist insbesondere einen Elektronenemitter auf, welcher kathodenseitig gegenüber von der Anode angeordnet ist. Der Elektronenemitter kann ein thermionischer oder ein kalter Emitter sein. Insbesondere Feldeffekt-Emitter sind kalte Emitter im Gegensatz zu thermionischen Emittern, welche durch das Aufheizen des Elektronenemitters die Elektronen erzeugen.

Zwischen der Kathode und der Anode liegt insbesondere eine Beschleunigungsspannung an, welche sich aus der positiven Röhrenspannung und der negativen Röhrenspannung zusammensetzt. Insbesondere liegt an der Kathode die negative Röhrenspannung und an der Anode die positive Röhrenspannung an. Mittels der Beschleunigungsspannung werden die Elektronen, welche an der Kathode emittiert werden, in Richtung der Anode beschleunigt. Die bei der Wechselwirkung mit der Anode generierte Röntgenstrahlung weist Röntgenphotonen auf, welche maximal die Energie der Beschleunigungsspannung mal der Elementarladung e aufweist.

Die Anode kann eine Drehanode oder eine Stehanode sein. Es ist denkbar, dass die Anode sich gemeinsam mit oder unabhängig von dem evakuierten Gehäuse dreht.

Das evakuierte Gehäuse umfasst insbesondere ein Hochvakuum und/oder kann insbesondere ein Glasgehäuse oder ein Metallgehäuse sein. Insbesondere wenn der Röntgenstrahler ein evakuiertes Metallgehäuse aufweist, kann ein geringer Teil der an der Kathode emittierten Elektronen über das Metallgehäuse abfließen. In diesem Fall ist das Metallgehäuse beispielsweise auf Massepotential verschaltet. Der Stromkreis zum Hochspannungsgenerator ist beispielsweise über den Masseanschluss des Hochspannungsgenerators geschlossen. Der Betrag des über der Anode fließenden Röhrenstroms ist in diesem Fall verschieden vom Betrag des über der Kathode fließenden Röhrenstroms. Insbesondere stellt der bipolare Hochspannungsgenerator einen positiven Röhrenstrom und einen negativen Röhrenstrom bereit, welche sich betragsmäßig unterscheiden. Der bipolare Hochspannungsgenerator wird in diesem Fall asymmetrisch betrieben.

Das Messsystem weist insbesondere den ersten Messkanal, den zweiten Messkanal, die Schnittstelle und die Steuerlogik auf. Das Messsystem ist insbesondere eine Schaltungsanordnung mit elektronischen Komponenten, welche den ersten Messkanal, den zweiten Messkanal, die Schnittstelle und die Steuerlogik bilden.

Der erste Messkanal und der zweite Messkanal können grundsätzlich strukturell identisch aufgebaut sein. Der erste Messkanal und der zweite Messkanal unterscheiden sich insbesondere in der Verschaltung mit dem bipolaren Hochspannungsgenerator, um die jeweiligen Messwerte erfassen zu können. Vorzugsweise unterscheiden sich der erste Messkanal und der zweite Messkanal lediglich in der Verschaltung mit dem bipolaren Hochspannungsgenerator. Beispielsweise ist also der erste Messkanal grundsätzlich dazu eingerichtet, zusätzlich oder alternativ den positiven Röhrenstrom und die positive Röhrenspannung zu erfassen, während der zweite Messkanal dazu eingerichtet sein kann, zusätzlich oder alternativ den negativen Röhrenstrom und die negative Röhrenspannung zu erfassen.

Der erste Messkanal und der zweite Messkanal sind insbesondere schaltungstechnisch unabhängig ausgebildet. Die Komponenten des ersten Messkanal und die Komponenten des zweiten Messkanals sind insbesondere separat voneinander ausgeführt und/oder jeweils vorhanden. Der erste Messkanal und der zweite Messkanal sind insbesondere ausschließlich mittels der Schnittstelle miteinander kommunikationsfähig verbunden.

Die folgenden Ausführungen in Bezug auf den ersten Messkanal, den negativen Röhrenstrom sowie die negative Röhrenspannung gelten gleichermaßen für den zweiten Messkanal, den positiven Röhrenstrom sowie die positive Röhrenspannung.

Der erste Messkanal weist für das Erfassen der negativen Röhrenspannung insbesondere einen Spannungsmesser auf. Der Spannungsmesser kann insbesondere einen Hochspannungsteiler umfassen.

Der erste Messkanal weist für das Erfassen des negativen Röhrenstroms insbesondere einen Strommesser auf. Der Strommesser kann insbesondere einen Messwiderstand umfassen.

Die negative Röhrenspannung kann insbesondere zeitaufgelöst erfasst werden. Der negative Röhrenstrom kann insbesondere zeitaufgelöst erfasst werden. Insbesondere können die ersten Messwerte zeitaufgelöst sein.

Der erste Messkanal ist insbesondere laufzeitfähig ausgebildet. Der erste Messkanal kann insbesondere die ersten Messwerte im Betrieb des bipolaren Hochspannungsgenerators laufzeitgetreu erfassen. Der erste Messkanal kann insbesondere den negativen Röhrenstrom und/oder die negative Röhrenspannung in Echtzeit überwachen. Eine Verzögerung bei der Erfassung der ersten Messwerte ist idealerweise lediglich laufzeitbedingt.

Das Erfassen des negativen Röhrenstroms und/oder der negativen Röhrenspannung umfasst insbesondere ein Messen des negativen Röhrenstroms mittels des Strommessers und/oder der negativen Röhrenspannung mittels des Hochspannungsteilers. Die erfassten negativen Röhrenstrommesswerte bilden einen ersten Teil der ersten Messwerte. Die erfassten positiven Röhrenspannungsmesswerte bilden einen zweiten Teil der ersten Messwerte. Die ersten Messwerte können aus den Röhrenstrommesswerten und den Röhrenspannungsmesswerten bestehen.

Das Erfassen des negativen Röhrenstroms und/oder der negativen Röhrenspannung kann ein Analog-Digital-Wandeln erfasster Messwerte umfassen. Dafür kann der erste Messkanal einen Analog-Digital-Wandler aufweisen.

Das Erfassen des negativen Röhrenstroms und/oder der negativen Röhrenspannung kann ein Aufbereiten und/oder ein Filtern erfasster Messwerte umfassen. Dafür kann der erste Messkanal einen Filter zum Aufbereiten und/oder Filtern der erfassten Messwerte umfassen.

Der erste Messkanal umfasst insbesondere einen ersten Erfassungspfad. Das Erfassen des negativen Röhrenstroms und/oder der negativen Röhrenspannung kann ein Weiterleiten der erfassten Messwerte über den ersten Erfassungspfad insbesondere an die Steuerlogik und/oder die Schnittstelle umfassen.

Die Schnittstelle zwischen dem ersten Messkanal und dem zweiten Messkanal ist insbesondere eine digitale Schnittstelle. Die Schnittstelle kann insbesondere für eine asynchrone oder synchrone sowie eine serielle oder parallele Kommunikation ausgebildet sein. Die Kommunikation zwischen dem ersten Messkanal und dem zweiten Messkanal kann insbesondere gemäß einem UART- oder SPI-Standard erfolgen.

Die Schnittstelle kann grundsätzlich unidirektional oder bidirektional ausgebildet sein. In jedem Fall ist die Schnittstelle derart ausgebildet, dass mittels der Schnittstelle die erfassten Messwerte eines Messkanals an den jeweils anderen Messkanal mit einer Steuerlogik übertragen werden können. Wenn die Schnittstelle zum Übertragen der ersten Messwerte und zum Übertragen der zweiten Messwerte ausgebildet ist, ist die Schnittstelle typischerweise bidirektional ausgebildet.

Das Übertragen umfasst insbesondere ein Senden sowie ein Empfangen der erfassten Messwerte und/oder erfolgt insbesondere mittels einer Koppeleinheit. Das Senden der erfassten Messwerte erfolgt insbesondere mittels einer Auskoppeleinheit. Das Empfangen erfolgt insbesondere mittels einer Einkoppeleinheit.

Die Schnittstelle kann beispielsweise einen Schnittstellenkanal oder mehrere Schnittstellenkanäle aufweisen. Der Schnittstellenkanal kann unidirektional oder bidirektional ausgebildet sein. Zwei der mehreren Schnittstellenkanäle können unidirektional mit entgegengesetzten Übertragungsrichtungen ausgebildet sein. Es ist denkbar, dass mindestens einer der mehreren Schnittstellenkanäle bidirektional ausgebildet ist.

Der erste Messkanal kann eine erste Einkoppeleinheit und/oder eine erste Auskoppeleinheit aufweisen, wobei die Schnittstelle mit der ersten Einkoppeleinheit und/oder der zweiten Auskoppeleinheit verbunden ist. Die erste Einkoppeleinheit und die erste Auskoppeleinheit bilden insbesondere eine erste Koppeleinheit des ersten Messkanals. Der zweite Messkanal kann eine zweite Einkoppeleinheit und/oder eine zweite Auskoppeleinheit aufweisen, wobei die Schnittstelle mit der zweiten Einkoppeleinheit und/oder der zweiten Auskoppeleinheit verbunden ist. Die zweite Einkoppeleinheit und die zweite Auskoppeleinheit bilden insbesondere eine zweite Koppeleinheit des ersten Messkanals.

Typischerweise ist ein Schnittstellenkanal mit einer Koppeleinheit, insbesondere einer Auskoppeleinheit, des einen Messkanals und einer Koppeleinheit, insbesondere einer Einkoppeleinheit, des anderen Messkanals verbunden. Es ist denkbar, dass die erste Einkoppeleinheit, die erste Auskoppeleinheit, die zweite Einkoppeleinheit, die zweite Auskoppeleinheit und die dazwischen liegenden Schnittstellenkanäle die Schnittstelle bilden.

Die Steuerlogik kann mit dem ersten Erfassungspfad direkt oder indirekt mittels der Schnittstelle verbunden sein. Die Steuerlogik kann die ersten Messwerte und die zweiten Messwerte an einer Eingangsschnittstelle empfangen und/oder abgreifen. Die Eingangsschnittstelle kann insbesondere mindestens vier Eingänge aufweisen. Die vier Eingänge können typischerweise bestehen aus einem negativen Röhrenstromeingang für den negativen Röhrenstrommesswert, einem negativen Röhrenspannungeingang für den negativen Röhrenspannungsmesswert, einem positiven Röhrenstromeingang für den positiven Röhrenstrommesswert und einem positiven Röhrenspannungseingang für den positiven Röhrenspannungsmesswert.

Die Steuerlogik kann insbesondere einen Logikbaustein und/oder einen Mikrocontroller und/oder einen Prozessor aufweisen. Die Steuerlogik weist insbesondere einen Speicher auf, in welchen Programmcodemitteln abgespeichert werden können. Für die Ausführung der Programmcodemitteln können die Programmcodemittel idealerweise von dem Speicher abgerufen werden. In den Programmcodemitteln ist insbesondere das Vergleichen und/oder das Ausgeben des Steuersignals abgebildet. Alternativ oder zusätzlich kann das Vergleichen und/oder das Ausgeben des Steuersignals in Logikbausteinen des Logikbausteins abgebildet sein. Die Steuerlogik bildet insbesondere eine Recheneinheit des Messsystems. Die Steuerlogik ist insbesondere ein Überwachungsbaustein des Messsystems.

Die Steuerlogik kann vor und/oder nach dem Vergleichen insbesondere die Messwerte aufbereiten und/oder filtern. Das Aufbereiten kann insbesondere ein Betragbilden und/oder ein Mittelwertbilden und/oder Integrieren und/oder ein Addieren und/oder ein Subtrahieren und/oder ein Multiplizieren und/oder Dividieren zweier, dreier oder aller Messwerte umfassen. Das Filtern kann insbesondere ein Glätten der Messwerte umfassen.

Die Steuerlogik kann insbesondere die empfangenen Messwerte seriell und/oder parallel vergleichen. Insbesondere kann die Steuerlogik zeitaufgelöste Messwerte vergleichen.

Das Vergleichen umfasst insbesondere ein Durchführen einer oder mehrerer Vergleichsoperationen. Eine Vergleichsoperation umfasst insbesondere mindestens eine mathematische Operation an mindestens einem Messwert und einem weiteren Wert, welcher ebenfalls ein anderer Messwert oder eine Konstante oder der mindestens eine Grenzwert sein kann. Ergebnis der Vergleichsoperation ist insbesondere eine Grenzwertverletzung oder Grenzwerteinhaltung.

Der mindestens eine Grenzwert ist beispielsweise in dem Speicher abgespeichert und/oder abrufbar. Es ist denkbar, dass die Speichereinheit zum Vergleichen der empfangenen Messwerte mit mehreren Grenzwerten ausgebildet ist. Insbesondere kann ein einzelner Messwert mit einem oder mehreren Grenzwerten verglichen werden. Der mindestens eine Grenzwert kann insbesondere ein Röhrenstromgrenzwert, ein Röhrenspannungsgrenzwert und/oder ein Leistungsgrenzwert sein. Typischerweise werden zwei, vorzugsweise alle empfangenen Messwerte mit dem mindestens einen Grenzwert oder mehreren Grenzwerten verglichen.

Die erfassten Messwerte sind insbesondere IST-Werte. Der mindestens eine Grenzwert ist insbesondere ein SOLL-Wert. Typischerweise wird jeder IST-Wert mit einem zugehörigen SOLL-Wert verglichen. Insbesondere der Röhrenstromgrenzwert, der Röhrenspannungsgrenzwert und/oder der Leistungsgrenzwert können SOLL-Werte sein.

Das Vergleichen mittels der Steuerlogik umfasst insbesondere ein Ermitteln, ob der verglichene Messwert den mindestens einen Grenzwert einhält oder verletzt. Das Einhalten des mindestens einen Grenzwerts kann ein Überschreiten oder ein Unterschreiten des mindestens einen Grenzwerts bedeuten. Das Verletzen des mindestens einen Grenzwerts kann ein Unterschreiten oder ein Überschreiten des mindestens einen Grenzwerts bedeuten. Beispielsweise gilt ein Überschreiten des mindestens einen Grenzwerts als Grenzwertverletzung, wenn der mindestens eine Grenzwert eine Obergrenze definiert. Beispielsweise gilt ein Unterschreiten des mindestens einen Grenzwerts als Grenzwertverletzung, wenn der mindestens eine Grenzwert eine Untergrenze definiert. Das Vergleichen mittels der Steuerlogik kann mit einem Absolutwert des empfangenen Messwerts und/oder einem vorzeichenbehafteten Messwert erfolgen.

Die Steuerlogik ist zu einem Unterscheiden der beim Vergleichen der empfangenen Messwerte erfolgenden Grenzwertverletzung und einer beim Vergleichen der empfangenen Messwerte erfolgenden Grenzwerteinhaltung ausgebildet. Vorteilhafterweise weist die Steuerlogik binäre Signalpfade auf, wobei automatisch und/oder unverzüglich und/oder unmittelbar ausschließlich der eine Signalpfad bei der Grenzwertverletzung angesteuert wird und ausschließlich der andere Signalpfad bei der Grenzwerteinhaltung angesteuert wird.

Die Steuerlogik weist insbesondere eine Ausgangsschnittstelle für das Ausgeben des Steuersignals aus. Das Steuersignal unterscheidet sich insbesondere bei einer Grenzwertüberschreitung von einer Grenzwerteinhaltung. Das Steuersignal kann variieren in Abhängigkeit von der Art des Messwerts, insbesondere ob Röhrenstrom oder Röhrenspannung oder Leistung. Das Steuersignal kann insbesondere einen Grad der Grenzwertüberschreitung differenziert abbilden. Das Ausgeben des Steuersignals umfasst insbesondere ein Übertragen des Steuersignals beispielsweise an den Hochspannungsgenerator und/oder den Röntgenstrahler und/oder ein audiovisuelles Ausgabesignal.

Eine Ausführungsform sieht vor, dass das Messsystem ferner eine weitere Steuerlogik zum Empfangen der ersten Messwerte sowie der zweiten Messwerte aufweist, wobei die Schnittstelle zum Übertragen der ersten Messwerte vom ersten Messkanal an die weitere Steuerlogik und zum Übertragen der zweiten Messwerte vom zweiten Messkanal an die Steuerlogik eingerichtet ist, wobei die weitere Steuerlogik zum Vergleichen der empfangenen Messwerte mit einem Grenzwert ausgebildet ist, wobei die weitere Steuerlogik zur Ausgabe eines Steuersignals in Abhängigkeit einer beim Vergleichen der empfangenen Messwerte erfolgenden Grenzwertverletzung ausgebildet ist.

Die vorherigen Ausführungen zur Struktur und Funktion der Steuerlogik gelten gleichermaßen für die weitere Steuerlogik. Erfindungsgemäß unterscheiden sich die Steuerlogik und die weitere Steuerlogik dahingehend, dass die Steuerlogik den ersten Erfassungspfad des ersten Messkanals abschließt und die weitere Steuerlogik den zweiten Erfassungspfad des zweiten Messkanals abschließt. In diesem Fall leitet der erste Erfassungspfad die ersten Messwerte direkt an die Steuerlogik weiter und der zweite Erfassungspfad leitet die zweiten Messwerte direkt an die weitere Steuerlogik weiter. Somit bilden der erste Messkanal sowie die Steuerlogik einen ersten unabhängigen Messbereich und der zweite Messkanal sowie die weitere Steuerlogik einen zweiten unabhängigen Messbereich. Vorteilhafterweise sind der erste Messbereich und der zweite Messbereich unmittelbar nur mittels der Schnittstelle verbunden.

Ein Vorteil dieser Ausführungsform ist, dass aufgrund der Redundanz des ersten Messbereichs und des zweiten Messbereichs eine erstfehlersichere Erfassung von Fehlern im Hochspannungsgenerator ermöglicht wird. Insbesondere kann ein Fehler in einem Hochspannungsteiler und/oder in einem Messwiderstand erstfehlerfrei erfasst werden.

Dieser Vorteil wird insbesondere dadurch erzielt, dass der erste Messbereich, insbesondere der erste Messkanal sowie die Steuerlogik, und der zweite Messbereich, insbesondere der zweite Messkanal sowie die weitere Steuerlogik, unabhängig voneinander und/oder redundant im Messsystem eingerichtet sind. Ferner erfolgt die Übertragung der mit dem einen Messkanal erfassten Messwerte an den jeweils anderen Messkanal mittels der Schnittstelle, so dass jeder Messbereich die Messwerte unabhängig voneinander vergleichen und/oder das Steuersignal ausgeben kann.

Eine Ausführungsform sieht vor, dass der mindestens eine Grenzwert ein Toleranzband definiert, wobei das Toleranzband derart festgelegt ist, dass es eine Abweichung der ersten Messwerte von den zweiten Messwerten größer null und insbesondere kleiner 50% einschließt, um einen asymmetrischen Betrieb des bipolaren Hochspannungsgenerators zu ermöglichen. Die Grenzwertverletzung eines Toleranzbands bedeutet, dass der verglichene Messwert außerhalb des Toleranzbands liegt. Die Grenzwerteinhaltung des Toleranzbands bedeutet, dass der verglichene Messwert innerhalb des Toleranzbands liegt.

Eine Ausführungsform sieht vor, dass beim Vergleichen eine Vergleichsoperation durchgeführt wird, wobei die eine Vergleichsoperation ein Subtrahieren eines Produkts der ersten Messwerte und eines Produkts der zweiten Messwerte vorgibt, wobei die Produktdifferenz mit dem mindestens einen Grenzwert verglichen wird. Diese Ausführungsform ist insbesondere vorteilhaft, um einen Grad der Asymmetrie über den Leistungsvergleich gemäß dem Produkt aus Röhrenstrom und Röhrenspannung festlegen und/oder erfassen zu können.

Eine Ausführungsform sieht vor, dass beim Vergleichen eine andere Vergleichsoperation durchgeführt wird, wobei die andere Vergleichsoperation ein Vergleichen der erfassten Messwerte des negativen Röhrenstroms und/oder des positiven Röhrenstroms mit einem Röhrenstromgrenzwert vorgibt. Diese Ausführungsform ist insbesondere vorteilhaft, weil eine Abweichung in Bezug auf den Röhrenstrom festgelegt und/oder erfasst werden kann.

Eine Ausführungsform sieht vor, dass beim Vergleichen eine weitere Vergleichsoperation durchgeführt wird, wobei die weitere Vergleichsoperation ein Vergleichen der erfassten Messwerte der negativen Röhrenspannung und/oder der positiven Röhrenspannung mit einem Röhrenspannungsgrenzwert vorgibt. Diese Ausführungsform ist insbesondere vorteilhaft, weil eine Abweichung in Bezug auf die Röhrenspannung festgelegt und/oder erfasst werden kann.

Eine Ausführungsform sieht vor, dass als Teil des Steuersignals die verglichenen Messwerte ausgegeben werden. In diesem Fall kann das Steuersignal insbesondere zusätzlich oder alternativ zum Röntgenstrahler bzw. Hochspannungsgenerator an eine Steuereinheit übertragen werden. Beispielsweise um ein Mitschreiben ("Logging") der Messwerte zu ermöglichen. Alternativ oder zusätzlich kann die Steuereinheit den Betrieb des Hochspannungsgenerators und/oder des Röntgenstrahlers in Abhängigkeit von den übertragenen Messwerten anpassen.

Eine Ausführungsform sieht vor, dass das Steuersignal derart ausgestaltet und das Messsystem derart mit einem bipolaren Hochspannungsgenerator verschaltet ist, dass das Ausgeben des Steuersignals ein Abschalten eines bipolaren Hochspannungsgenerators bewirkt. Diese Ausführungsform ist insbesondere vorteilhaft, weil bei der Grenzüberschreitung der bipolare Hochspannungsgenerator abgeschaltet werden kann. Beispielsweise direkt mittels des Steuersignals von der Steuerlogik und/oder mittels der Steuereinheit, an welche das Steuersignal übertragen wird von der Steuerlogik.

Eine Ausführungsform sieht vor, dass beim Abschalten des bipolaren Hochspannungsgenerators mittels des Steuersignals ein Wechselrichter des bipolaren Hochspannungsgenerators abgeschaltet wird. Beispielsweise kann das Steuersignal vorgeben, dass der Wechselrichter abgeschaltet wird.

Das Computerprogrammprodukt kann ein Computerprogramm sein oder ein Computerprogramm umfassen. Das Computerprogrammprodukt weist insbesondere die Programmcodemittel auf, welche die erfindungsgemäßen Verfahrensschritte abbilden. Dadurch kann das erfindungsgemäße Verfahren definiert und wiederholbar ausgeführt sowie eine Kontrolle über eine Weitergabe des erfindungsgemäßen Verfahrens ausgeübt werden. Das Computerprogrammprodukt ist vorzugsweise derart konfiguriert, dass die Recheneinheit mittels des Computerprogrammprodukts die erfindungsgemäßen Verfahrensschritte ausführen kann. Die Programmcodemittel können insbesondere in einen Speicher der Recheneinheit geladen und typischerweise mittels eines Prozessors der Recheneinheit mit Zugriff auf den Speicher ausgeführt werden. Wenn das Computerprogrammprodukt, insbesondere die Programmcodemittel, in der Recheneinheit ausgeführt wird, können typischerweise alle erfindungsgemäßen Ausführungsformen des beschriebenen Verfahrens durchgeführt werden. Das Computerprogrammprodukt ist beispielsweise auf einem physischen, computerlesbaren Medium gespeichert und/oder digital als Datenpaket in einem Computernetzwerk hinterlegt. Das Computerprogrammprodukt kann das physische, computerlesbare Medium und/oder das Datenpaket in dem Computernetzwerk darstellen. So kann die Erfindung auch von dem physischen, computerlesbaren Medium und/oder dem Datenpaket in dem Computernetzwerk ausgehen. Das physische, computerlesbare Medium ist üblicherweise unmittelbar mit der Recheneinheit verbindbar, beispielsweise indem das physische, computerlesbare Medium in ein DVD-Laufwerk eingelegt oder in einen USB-Port gesteckt wird, wodurch die Recheneinheit auf das physische, computerlesbare Medium insbesondere lesend zugreifen kann. Das Datenpaket kann vorzugsweise aus dem Computernetzwerk abgerufen werden. Das Computernetzwerk kann die Recheneinheit aufweisen oder mittels einer Wide-Area-Network- (WAN) bzw. einer (Wireless-)Local-Area-Network-Verbindung (WLAN oder LAN) mit der Recheneinheit mittelbar verbunden sein. Beispielsweise kann das Computerprogrammprodukt digital auf einem Cloud-Server an einem Speicherort des Computernetzwerks hinterlegt sein, mittels des WAN über das Internet und/oder mittels des WLAN bzw. LAN auf die Recheneinheit insbesondere durch das Aufrufen eines Downloadlinks, welcher zu dem Speicherort des Computerprogrammprodukts verweist, übertragen werden.

Bei der Beschreibung der Vorrichtung erwähnte Merkmale, Vorteile oder alternative Ausführungsformen sind ebenso auf das Verfahren zu übertragen und umgekehrt. Mit anderen Worten können Ansprüche auf das Verfahren mit Merkmalen der Vorrichtung weitergebildet sein und umgekehrt. Insbesondere kann die erfindungsgemäße Vorrichtung in dem Verfahren verwendet werden.

Im Folgenden wird die Erfindung anhand der in den Figuren dargestellten Ausführungsbeispiele näher beschrieben und erläutert. Grundsätzlich werden in der folgenden Figurenbeschreibung im Wesentlichen gleich bleibende Strukturen und Einheiten mit demselben Bezugszeichen wie beim erstmaligen Auftreten der jeweiligen Struktur oder Einheit benannt.

Es zeigen:
Fig. 1 ein Messsystem für einen bipolaren Hochspannungsgenerator,
Fig. 2 das Messsystem in einer ersten Ausführungsform,
Fig. 3 ein Verfahren zum Ausgeben eines Steuersignals mittels eines Messsystems,
Fig. 4 das Verfahren in einer ersten Ausführungsform,
Fig. 5 das Verfahren in einer zweiten Ausführungsform und
Fig. 6 das Verfahren in einer dritten Ausführungsform.

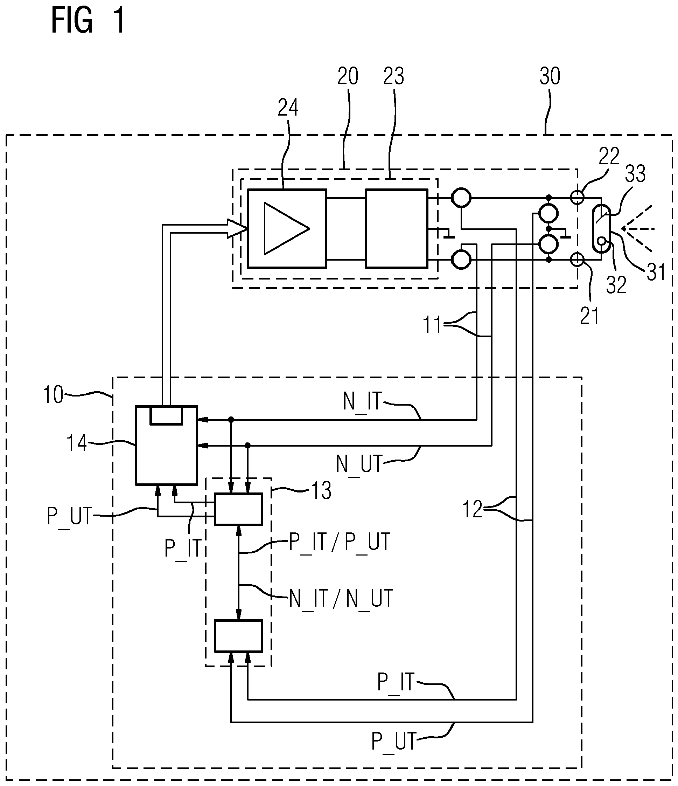

**Fig. 1** zeigt ein erfindungsgemäßes Messsystem für einen bipolaren Hochspannungsgenerator in einem Blockschaltdiagramm.

Das Messsystem 10 ist in Fig. 1 als Teil eines bipolaren Hochspannungsgenerator 20 gezeigt. Der bipolare Hochspannungsgenerator 20 ist zur Erzeugung eines negativen Röhrenstroms N_IT, einer negativen Röhrenspannung N_UT, eines positiven Röhrenstroms P_IT und einer positiven Röhrenspannung P_UT ausgebildet. Der bipolare Hochspannungsgenerator 20 weist ferner einen negativen Hochspannungsausgang 21 und einen positiven Hochspannungsausgang 22 auf. Am negativen Hochspannungsausgang 21 sind der negative Röhrenstrom N_IT und die negative Röhrenspannung N_UT bereitstellbar. Am positiven Hochspannungsausgang 22 sind der positive Röhrenstrom P_IT und die positive Röhrenspannung P_UT bereitstellbar.

Der bipolare Hochspannungsgenerator 20 weist ferner eine Hochspannungseinheit 23 für das Erzeugen der Röhrenströme N_IT, P_IT und der Röhrenspannungen N_UT, P_UT auf. Die Hochspannungseinheit 23 weist einen Wechselrichter 24 auf.

Das Messsystem 10 weist einen ersten Messkanal 11 zum Erfassen des negativen Röhrenstroms N_IT und der negativen Röhrenspannung N_UT und einen zweiten Messkanal 12 zum Erfassen des positiven Röhrenstroms P_IT und der positiven Röhrenspannung P_UT. Der erste Messkanal 11 ist mit dem negativen Hochspannungsausgang 21 verschaltet. Der zweite Messkanal 12 ist mit dem positiven Hochspannungsausgang 22 verschaltet.

Das Messsystem 10 weist ferner eine Schnittstelle 13 zwischen dem ersten Messkanal 11 und dem zweiten Messkanal 12 auf. Die Schnittstelle 13 ist zum Übertragen mittels des ersten Messkanals 11 erfasster erster Messwerte des negativen Röhrenstroms N_IT und der negativen Röhrenspannung N_UT und/oder mittels des zweiten Messkanals 12 erfasster zweiter Messwerte des positiven Röhrenstroms P_IT und der positiven Röhrenspannung P_UT ausgebildet.

Das Messsystem 10 weist ferner eine Steuerlogik 14 zum Empfangen der ersten Messwerte sowie der zweiten Messwerte auf. Die Steuerlogik 14 ist zum Vergleichen der empfangenen Messwerte mit mindestens einem Grenzwert ausgebildet. Die Steuerlogik 14 ist zum Ausgeben eines Steuersignals in Abhängigkeit einer beim Vergleichen der empfangenen Messwerte erfolgenden Grenzwertverletzung ausgebildet.

Der bipolare Hochspannungsgenerator 20 ist in Fig. 1 als Teil eines Röntgenstrahlers 30 gezeigt. Der Röntgenstrahler 30 weist ferner ein evakuiertes Gehäuse 31, eine Kathode 32 und eine Anode 33 auf. Die Kathode 32 und die Anode 33 sind innerhalb des evakuierten Gehäuses 31 angeordnet. Die Anode 33 ist mit dem positiven Hochspannungsausgang 22 verschaltet. Die Kathode 21 ist mit dem negativen Hochspannungsausgang 21 verschaltet.

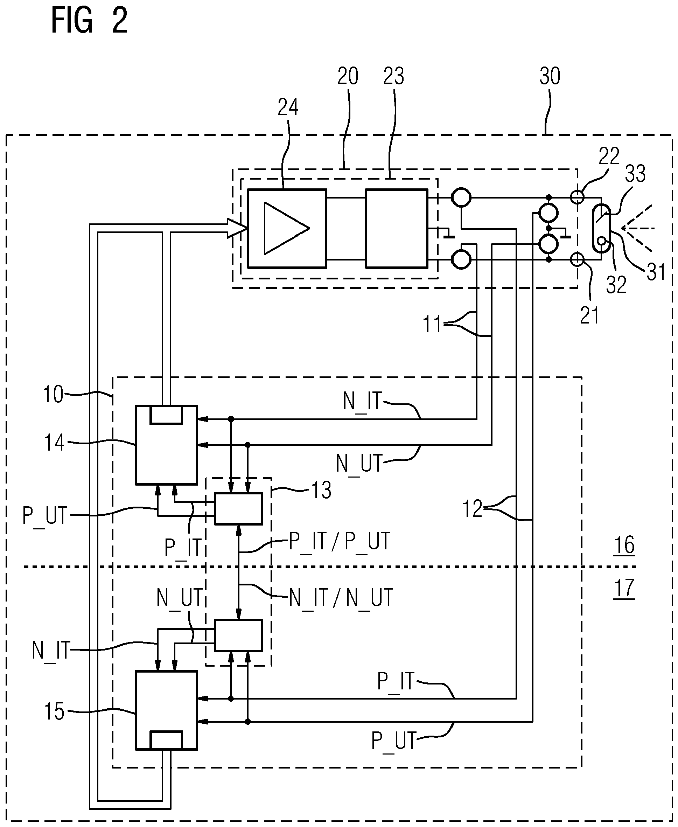

**Fig. 2** zeigt ein erstes Ausführungsbeispiel des Messystems 10 in einem Blockschaltdiagramm.

Das Messsystem 10 weist ferner eine weitere Steuerlogik 15 zum Empfangen der ersten Messwerte sowie der zweiten Messwerte auf. Die Schnittstelle 13 ist zum Übertragen der ersten Messwerte vom ersten Messkanal 11 an die weitere Steuerlogik 15 und zum Übertragen der zweiten Messwerte vom zweiten Messkanal 12 an die Steuerlogik 14 eingerichtet. Die weitere Steuerlogik 15 ist zum Vergleichen der empfangenen Messwerte mit einem Grenzwert ausgebildet. Die weitere Steuerlogik 15 ist zur Ausgabe eines Steuersignals in Abhängigkeit einer beim Vergleichen der empfangenen Messwerte erfolgenden Grenzwertverletzung ausgebildet.

In dieser Ausführungsform bilden der erste Messkanal 11 sowie die Steuerlogik 14 einen ersten unabhängigen Messbereich 16 und der zweite Messkanal 12 sowie die weitere Steuerlogik 15 einen zweiten unabhängigen Messbereich 17. Der erste Messbereich 16 und der zweite Messbereich 17 sind unmittelbar nur mittels der Schnittstelle 13 verbunden. In Fig. 2 sind die beiden Messbereiche 16, 17 mittels der gestrichelten Linie separiert dargestellt.

Ferner sind in diesem Ausführungsbeispiel in den Erfassungspfaden für die Messwerte N_IT, N_UT, P_IT, P_UT vier Digital-Analog-Wandler eingesetzt. Gemäß einer Weiterbildung definiert der mindestens eine Grenzwert ein Toleranzband, wobei das Toleranzband derart festgelegt ist, dass es eine Abweichung der ersten Messwerte von den zweiten Messwerten größer null und insbesondere kleiner 50% abbildet, um einen asymmetrischen Betrieb des bipolaren Hochspannungsgenerators zu ermöglichen. Die ersten Messwerte und/oder die zweiten Messwerte können insbesondere zeitaufgelöst sein.

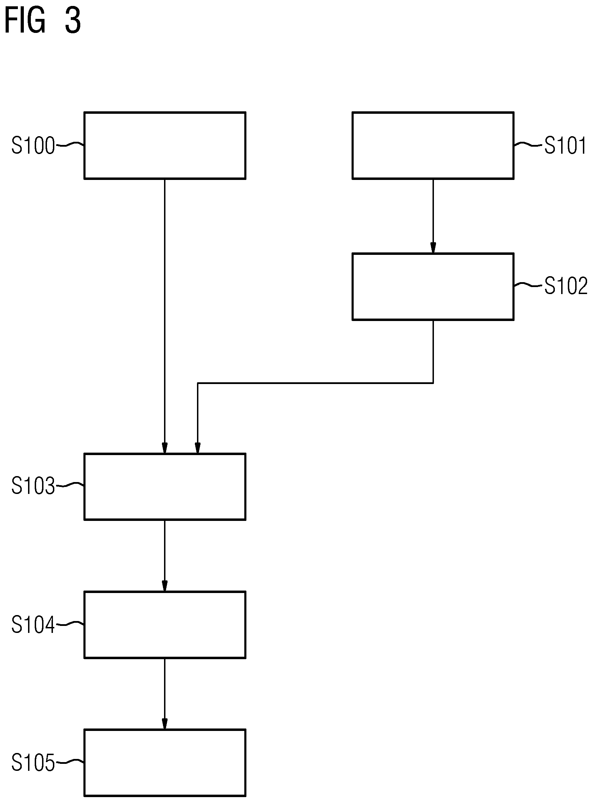

**Fig. 3** zeigt ein Verfahren zum Ausgeben eines Steuersignals mittels eines Messsystems in einem Flussdiagramm mit den Verfahrensschritten S100 bis S105:
Verfahrensschritt S100 kennzeichnet ein Erfassen eines negativen Röhrenstroms N_IT und einer negativen Röhrenspannung N_UT mittels eines ersten Messkanals 11 des Messsystems 10.

Verfahrensschritt S101 kennzeichnet ein Erfassen eines positiven Röhrenstroms P_IT und einer positiven Röhrenspannung P_UT mittels eines zweiten Messkanals 12 des Messsystems 10.

Verfahrensschritt S102 kennzeichnet ein Übertragen mittels des zweiten Messkanals 12 erfasster zweiter Messwerte des positiven Röhrenstroms P_IT und der positiven Röhrenspannung P_UT mittels der Schnittstelle 13 des Messsystems 10.

Verfahrensschritt S103 kennzeichnet ein Empfangen der ersten Messwerte sowie der zweiten Messwerte mittels einer Steuerlogik 14 des Messsystems 10.

Verfahrensschritt S104 kennzeichnet ein Vergleichen der empfangenen Messwerte mit mindestens einem Grenzwert mittels der Steuerlogik 14.

Verfahrensschritt S105 kennzeichnet ein Ausgeben eines Steuersignals in Abhängigkeit einer beim Vergleichen der empfangenen Messwerte erfolgten Grenzwertverletzung mittels der Steuerlogik 14.

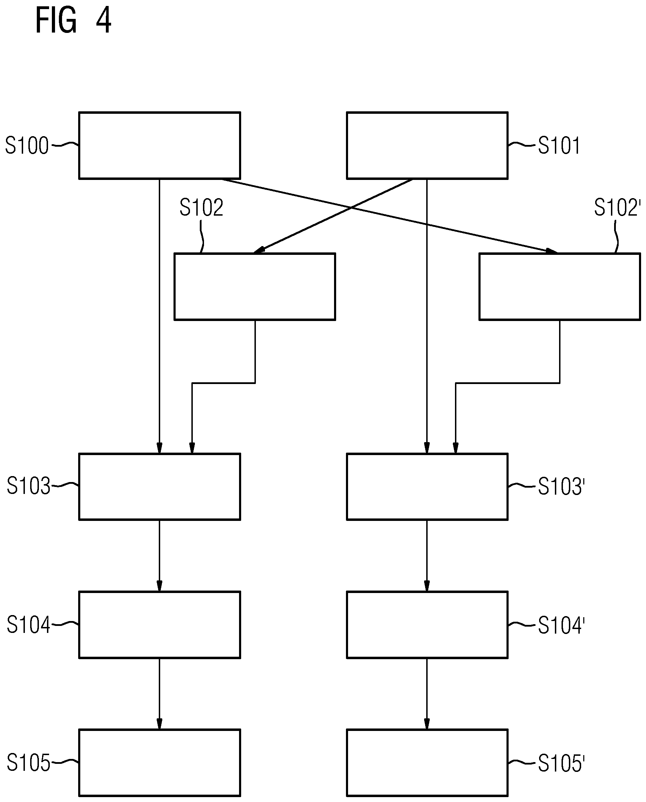

**Fig. 4** zeigt ein erstes Ausführungsbeispiel des Verfahrens in einem Flussdiagramm.

Verfahrensschritt S102' kennzeichnet ein Übertragen mittels des ersten Messkanals 11 erfasster erster Messwerte des negativen Röhrenstroms N_IT und der negativen Röhrenspannung N_UT mittels einer Schnittstelle 13 des Messsystems 10.

Verfahrensschritt S103' kennzeichnet ein Empfangen der ersten Messwerte sowie der zweiten Messwerte mittels einer weiteren Steuerlogik 15 des Messsystems 10.

Verfahrensschritt S104' kennzeichnet ein Vergleichen der empfangenen Messwerte mit mindestens einem Grenzwert mittels der weiteren Steuerlogik 15.

Verfahrensschritt S105' kennzeichnet ein Ausgeben eines Steuersignals in Abhängigkeit einer beim Vergleichen der empfangenen Messwerte erfolgten Grenzwertverletzung mittels der weiteren Steuerlogik 15.

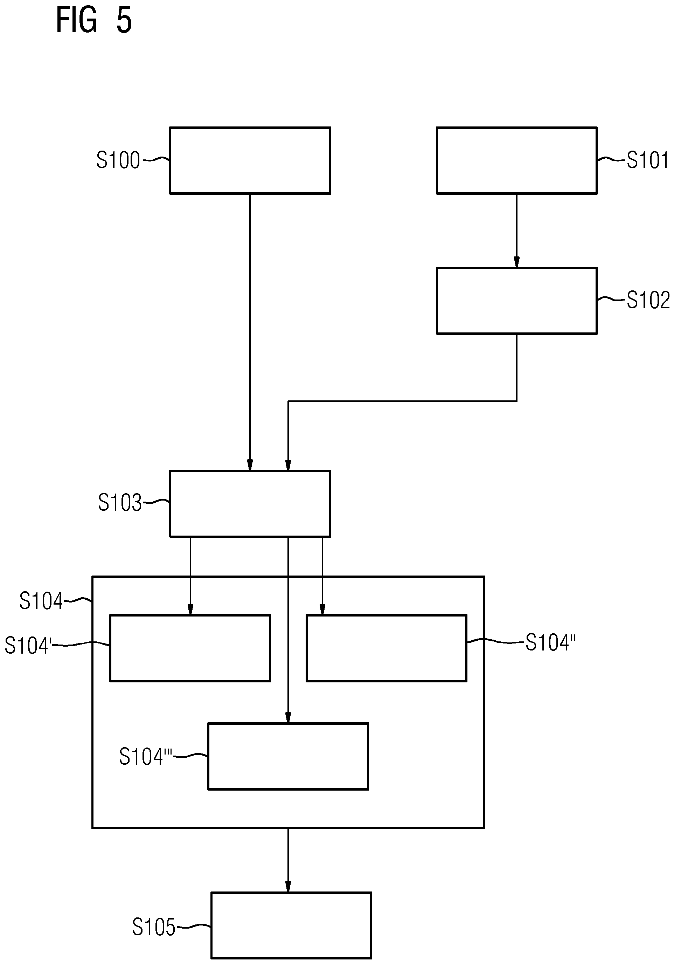

**Fig. 5** zeigt ein zweites Ausführungsbeispiel des Verfahrens in einem Flussdiagramm.

Verfahrensschritt S104' kennzeichnet, dass beim Vergleichen eine Vergleichsoperation durchgeführt wird, wobei die eine Vergleichsoperation ein Subtrahieren eines Produkts der ersten Messwerte und eines Produkts der zweiten Messwerte vorgibt, wobei die Produktdifferenz mit dem mindestens einen Grenzwert verglichen wird.

Verfahrensschritt S104" kennzeichnet, dass beim Vergleichen eine andere Vergleichsoperation durchgeführt wird, wobei die andere Vergleichsoperation ein Vergleichen der erfassten Messwerte des negativen Röhrenstroms N_IT und/oder des positiven Röhrenstroms P_IT mit einem Röhrenstromgrenzwert vorgibt.

Verfahrensschritt S104‴ kennzeichnet, dass beim Vergleichen eine weitere Vergleichsoperation durchgeführt wird, wobei die weitere Vergleichsoperation ein Vergleichen der erfassten Messwerte der negativen Röhrenspannung N_UT und/oder der positiven Röhrenspannung P_UT mit einem Röhrenspannungsgrenzwert vorgibt.

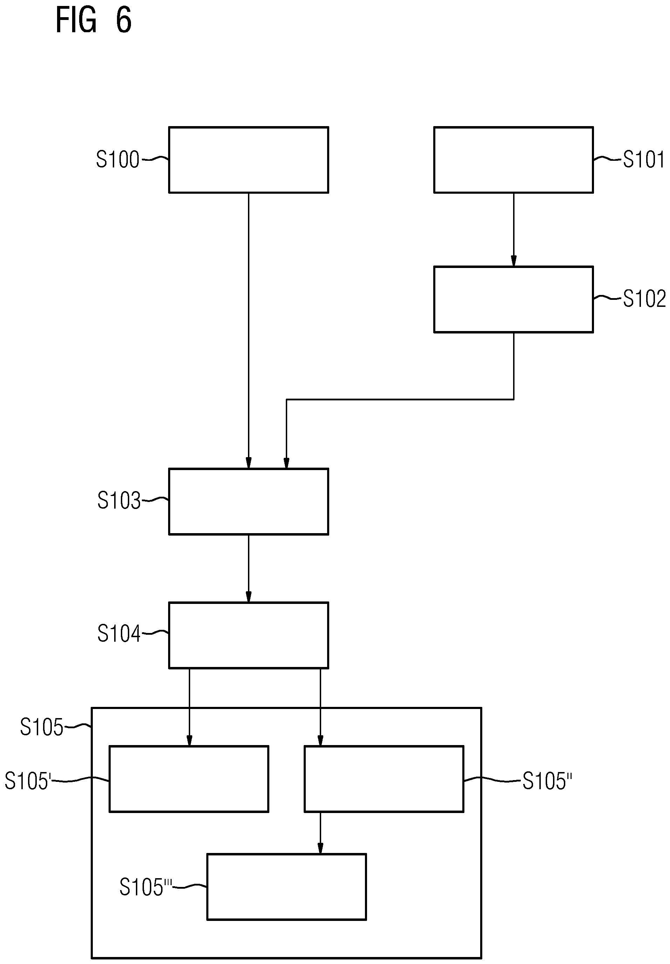

**Fig. 6** zeigt ein drittes Ausführungsbeispiel des Verfahrens in einem Flussdiagramm.

Verfahrensschritt S105' kennzeichnet, dass als Teil des Steuersignals die verglichenen Messwerte ausgegeben werden.

Verfahrensschritt S105" kennzeichnet, dass das Steuersignal derart ausgestaltet und das Messsystem derart mit einem bipolaren Hochspannungsgenerator verschaltet ist, dass das Ausgeben des Steuersignals ein Abschalten eines bipolaren Hochspannungsgenerators bewirkt.

Verfahrensschritt S105‴ kennzeichnet, dass beim Abschalten des bipolaren Hochspannungsgenerators mittels des Steuersignals ein Wechselrichter des bipolaren Hochspannungsgenerators abgeschaltet wird.

Obwohl die Erfindung im Detail durch die bevorzugten Ausführungsbeispiele näher illustriert und beschrieben wurde, so ist die Erfindung dennoch nicht durch die offenbarten Beispiele eingeschränkt und andere Variationen können vom Fachmann hieraus abgeleitet werden, ohne den Schutzumfang der Erfindung zu verlassen.

## Patentansprüche

1. Messsystem (10) für einen bipolaren Hochspannungsgenerator (20), wobei der bipolare Hochspannungsgenerator (20) zur Erzeugung eines negativen Röhrenstroms (N_IT), einer negativen Röhrenspannung (N_UT), eines positiven Röhrenstroms (P_IT) und einer positiven Röhrenspannung (P_UT) ausgebildet ist, aufweisend
- einen ersten Messkanal (11) zum Erfassen des negativen Röhrenstroms (N_IT) und der negativen Röhrenspannung (N_UT),
- einen zweiten Messkanal (12) zum Erfassen des positiven Röhrenstroms (N_IT) und der positiven Röhrenspannung (N_IT), **gekennzeichnet durch**
- eine Schnittstelle (13) zwischen dem ersten Messkanal (11) und dem zweiten Messkanal (12), wobei die Schnittstelle (11) zum Übertragen mittels des ersten Messkanals (11) erfasster erster Messwerte des negativen Röhrenstroms (N_IT) und der negativen Röhrenspannung (N_UT) und/oder mittels des zweiten Messkanals (12) erfasster zweiter Messwerte des positiven Röhrenstroms (P_IT) und der positiven Röhrenspannung (P_UT) ausgebildet ist,
- eine Steuerlogik (14) zum Empfangen der ersten Messwerte sowie der zweiten Messwerte,
- wobei die Steuerlogik (14) zum Vergleichen der empfangenen Messwerte mit mindestens einem Grenzwert ausgebildet ist,
- wobei die Steuerlogik (14) zum Ausgeben eines Steuersignals in Abhängigkeit einer beim Vergleichen der empfangenen Messwerte erfolgenden Grenzwertverletzung ausgebildet ist.

2. Messsystem (10) nach Anspruch 1,
- wobei das Messsystem (10) ferner eine weitere Steuerlogik (15) zum Empfangen der ersten Messwerte sowie der zweiten Messwerte aufweist,
- wobei die Schnittstelle (13) zum Übertragen der ersten Messwerte vom ersten Messkanal (11) an die weitere Steuerlogik (15) und zum Übertragen der zweiten Messwerte vom zweiten Messkanal (12) an die Steuerlogik (14) eingerichtet ist,
- wobei die weitere Steuerlogik (15) zum Vergleichen der empfangenen Messwerte mit einem Grenzwert ausgebildet ist,
- wobei die weitere Steuerlogik (15) zur Ausgabe eines Steuersignals in Abhängigkeit einer beim Vergleichen der empfangenen Messwerte erfolgenden Grenzwertverletzung ausgebildet ist.

3. Messsystem (10) nach einem der vorhergehenden Ansprüche, wobei der erste Messkanal (11) sowie die Steuerlogik (14) einen ersten unabhängigen Messbereich (16) und der zweite Messkanal (12) sowie die weitere Steuerlogik (15) einen zweiten unabhängigen Messbereich (17) bilden, wobei der erste Messbereich (16) und der zweite Messbereich (17) unmittelbar nur mittels der Schnittstelle (13) verbunden sind.

4. Messsystem (10) nach einem der vorhergehenden Ansprüche, wobei der mindestens eine Grenzwert ein Toleranzband definiert, wobei das Toleranzband derart festgelegt ist, dass es eine Abweichung der ersten Messwerte von den zweiten Messwerten größer null und insbesondere kleiner 50% abbildet, um einen asymmetrischen Betrieb des bipolaren Hochspannungsgenerators (20) zu ermöglichen.

5. Messsystem (10) nach einem der vorhergehenden Ansprüche, wobei die ersten Messwerte und/oder die zweiten Messwerte zeitaufgelöst sind.

6. Bipolarer Hochspannungsgenerator (20) zur Erzeugung eines negativen Röhrenstroms (N_IT), einer negativen Röhrenspannung (N_UT), eines positiven Röhrenstroms (P_IT) und einer positiven Röhrenspannung (P_UT), aufweisend
- ein Messsystem (10) nach einem der vorhergehenden Ansprüche,
- einen negativen Hochspannungsausgang (21), an welchem der negative Röhrenstrom (N_IT) und die negative Röhrenspannung (N_UT) bereitstellbar sind,
- einen positiven Hochspannungsausgang (22), an welchem der positive Röhrenstrom (P_IT) und die positive Röhrenspannung (P_UT) bereitstellbar sind,
- wobei der erste Messkanal (11) mit dem negativen Hochspannungsausgang (21) für das Erfassen des negativen Röhrenstroms (N_IT) und der negativen Röhrenspannung (N_UT) verschaltet ist,
- wobei der zweite Messkanal (12) mit dem positiven Hochspannungsausgang (22) für das Erfassen des positiven Röhrenstroms (P_IT) und der positiven Röhrenspannung (P_UT) verschaltet ist.

7. Röntgenstrahler (30), aufweisend
- einen bipolaren Hochspannungsgenerator (20) nach Anspruch 6,
- ein evakuiertes Gehäuse (31),
- eine Kathode (32) und
- eine Anode (33),
- wobei die Kathode (32) und die Anode (33) innerhalb des evakuierten Gehäuses (31) angeordnet sind,
- wobei die Anode (33) mit dem positiven Hochspannungsausgang (22) verschaltet ist und
- wobei die Kathode (32) mit dem negativen Hochspannungsausgang (21) verschaltet ist.

8. Verfahren zum Ausgeben eines Steuersignals mittels eines Messsystems (10) insbesondere nach einem der vorhergehenden Ansprüche, umfassend die Schritte:
- Erfassen (S100) eines negativen Röhrenstroms (N_IT) und einer negativen Röhrenspannung (N_UT) mittels eines ersten Messkanals (11) des Messsystems (10),
- Erfassen (S101) eines positiven Röhrenstroms (P_IT) und einer positiven Röhrenspannung (P_UT) mittels eines zweiten Messkanals (12) des Messsystems (10),
- Übertragen (S102, S102') mittels des ersten Messkanals erfasster erster Messwerte des negativen Röhrenstroms (N_IT) und der negativen Röhrenspannung (N_UT) und/oder mittels des zweiten Messkanals (12) erfasster zweiter Messwerte des positiven Röhrenstroms (P_IT) und der positiven Röhrenspannung (P_UT) mittels einer Schnittstelle (13) des Messsystems (10),
- Empfangen (S103) der ersten Messwerte sowie der zweiten Messwerte mittels einer Steuerlogik (14) des Messsystems (10),
- Vergleichen (S104) der empfangenen Messwerte mit mindestens einem Grenzwert mittels der Steuerlogik (14),
- Ausgeben (S105) eines Steuersignals in Abhängigkeit einer beim Vergleichen der empfangenen Messwerte erfolgten Grenzwertverletzung mittels der Steuerlogik (14).

9. Verfahren nach Anspruch 8,
wobei beim Vergleichen (S104) eine Vergleichsoperation (S104') durchgeführt wird, wobei die eine Vergleichsoperation ein Subtrahieren eines Produkts der ersten Messwerte und eines Produkts der zweiten Messwerte vorgibt, wobei die Produktdifferenz mit dem mindestens einen Grenzwert verglichen wird.

10. Verfahren nach einem der Ansprüche 8 bis 9,
wobei beim Vergleichen (S104) eine andere Vergleichsoperation (S104") durchgeführt wird, wobei die andere Vergleichsoperation ein Vergleichen der erfassten Messwerte des negativen Röhrenstroms und/oder des positiven Röhrenstroms mit einem Röhrenstromgrenzwert vorgibt.

11. Verfahren nach einem der Ansprüche 8 bis 10,
wobei beim Vergleichen (S104) eine weitere Vergleichsoperation (S104‴) durchgeführt wird, wobei die weitere Vergleichsoperation ein Vergleichen der erfassten Messwerte der negativen Röhrenspannung und/oder der positiven Röhrenspannung mit einem Röhrenspannungsgrenzwert vorgibt.

12. Verfahren nach einem der Ansprüche 8 bis 11,
wobei (S105') als Teil des Steuersignals die verglichenen Messwerte ausgegeben werden.

13. Verfahren nach einem der Ansprüche 8 bis 12,
wobei das Steuersignal derart ausgestaltet und das Messsystem (10) derart mit einem bipolaren Hochspannungsgenerator (20) verschaltet ist, dass das Ausgeben (S105) des Steuersignals ein Abschalten (S105") eines bipolaren Hochspannungsgenerators (20) bewirkt.

14. Verfahren nach Anspruch 13,
wobei beim Abschalten (S105) des bipolaren Hochspannungsgenerators (20) mittels des Steuersignals (S105‴) ein Wechselrichter (24) des bipolaren Hochspannungsgenerators (20) abgeschaltet wird.

15. Computerprogrammprodukt, welches direkt in einen Speicher einer Recheneinheit eines Messsystems ladbar ist, mit Programmcodemitteln, um ein Verfahren nach einem der Ansprüche 8 bis 14 auszuführen, wenn das Computerprogrammprodukt in der Recheneinheit ausgeführt wird.
